# EUROPEAN PATENT APPLICATION

(11) **EP 4 604 398 A1**
(43) Date of publication of application: **20.08.2025**
(21) Application number: 25156328.4
(22) Date of filing: 06.02.2025
(51) Int. Cl.: H03K 17/95

(54) **PROXIMITY SENSOR**

(30) Priority: 16.02.2024 JP 2024022090
(71) Applicant: Keyence Corporation, Osaka-shi, Osaka 533-8555 (JP)
(72) Inventor: KASHIMA, Hiroshi, Osaka-shi, Osaka,, 533-8555 (JP); TANAKA, Satsuki, Osaka-shi, Osaka,, 533-8555 (JP)
(74) Representative: Winter, Brandl - Partnerschaft mbB

(57) **Abstract**

Provided is a proximity sensor capable of sufficiently extending a detection distance by suppressing an influence of embedded metal. The proximity sensor includes a first coil, a second coil, a transmission circuit, a ferrite core, a reception circuit, a control circuit, and an electric shield. The second coil disposed radially outside the first coil. The transmission circuit periodically applies a pulsed excitation current to at least one of the coils. The control circuit detects the detection object D based on the change in the detected voltage or current generated in at least one of the coils by the magnetic field. The electric shield is a press-molded product having a bottomed tubular shape disposed outside the second coil in the radial direction and having a peripheral portion and a detection surface portion in which a cut crossing a direction around an axis is formed.

## Description

### BACKGROUND OF THE INVENTION

### 1. TECHNICAL FIELD

The invention relates to a proximity sensor.

### 2. DESCRIPTION OF THE RELATED ART

JP 2018-152320 A discloses a proximity sensor. The proximity sensor described in JP 2018-152320 A reduces an influence of a change in coil characteristics and the like.

As illustrated in FIG. 3 of JP 2018-152320 A, the proximity sensor of JP 2018-152320 A is used by being embedded in nuts and washers of reference numerals 7 to 9.

Meanwhile, the proximity sensor may fail if it comes into contact with an object to be detected (hereinafter, the detection object) and its peripheral members. For this reason, the proximity sensor is required to extend a distance to be detected (hereinafter, the detection distance) in order to avoid contact with the detection object or the like.

In order to extend the detection distance, the proximity sensor also needs to detect a weak change in the reception waveform. However, since the proximity sensor described in JP 2018-152320 A cannot detect a weak change in the reception waveform due to the influence of an embedded nut, a washer, or the like (hereinafter, an embedded metal), the detection distance cannot be sufficiently extended.

### SUMMARY OF THE INVENTION

The invention has been made in view of the above problems, and an object thereof is to provide a proximity sensor capable of sufficiently extending a detection distance by suppressing an influence of embedded metal.

According to one aspect of the invention, a proximity sensor includes a coil, a transmission circuit, and a ferrite core. The coil generates a magnetic field by an excitation current. The transmission circuit periodically applies a pulsed excitation current to the coil. The ferrite core guides a magnetic field generated from the coil. The coil includes a first coil and a second coil. The second coil is disposed concentrically with the first coil. The proximity sensor further includes a reception circuit, a control circuit, and an electric shield. The reception circuit detects a voltage or a current generated in at least any one of the first coil and the second coil by the magnetic field which is changed by the detection object. The control circuit detects the detection object D on the basis of the change in the voltage or the current detected by the reception circuit. The electric shield has a bottomed cylindrical shape disposed outside the second coil in the radial direction. The electric shield includes a peripheral portion and a detection surface portion. The peripheral portion covers the second coil from the outside in the radial direction. The detection surface portion is located on the side where the detection object is detected. In the electric shield, a cut crossing the direction around the axis is formed in the detection surface portion and the peripheral portion. The electric shield is a press-molded product of a punched thin metal plate in a sheet metal configuration.

According to the proximity sensor of the invention, the detection distance can be sufficiently extended by suppressing the influence of the embedded metal.

### BRIEF DESCRIPTION OF THE DRAWINGS

FIG. 1 is an external view of a proximity sensor;
FIG. 2 is an external view of the proximity sensor in a used state;
FIG. 3 is an exploded perspective view from a coil constituting the proximity sensor to a substrate;
FIG. 4 is an exploded perspective view of components housed in a casing of the proximity sensor;
FIG. 5 is a central longitudinal sectional view of the proximity sensor;
FIG. 6 is a block diagram for explaining a main circuit configuration of the proximity sensor;
FIG. 7 is a block diagram for explaining a main circuit configuration of the proximity sensor in detail;
FIG. 8A is a graph illustrating an image of a reception waveform in a case where there is no embedded metal and a detection object is not within a detection range;
FIG. 8B is a graph illustrating an image of a reception waveform in a case where there is no embedded metal and a detection object is within a detection range;
FIG. 9A is a graph illustrating an image of a reception waveform in a case where there is embedded metal and a detection object is not within a detection range;
FIG. 9B is a graph illustrating an image of a reception waveform in a case where there is an embedded metal and a detection object is within a detection range;
FIG. 10A is a graph illustrating an image of a reception waveform adjusted to 0 in a case where there is no embedded metal and a detection object is not within a detection range;
FIG. 10B is a graph illustrating an image of a reception waveform adjusted to 0 in a case where there is no embedded metal and a detection object is within a detection range;
FIG. 11A is a graph illustrating an image of a reception waveform adjusted to 0 in a case where there is an embedded metal and a detection object is not within a detection range;
FIG. 11B is a graph illustrating an image of a reception waveform adjusted to 0 in a case where there is an embedded metal and a detection object is within a detection range;
FIG. 12 is a view for explaining sizes and arrangements of the first coil and the second coil;
FIG. 13A is a central longitudinal sectional view in a state in which the influence of an embedded metal is slightly suppressed;
FIG. 13B is a central longitudinal sectional view in a state in which the influence of an embedded metal is further suppressed;
FIG. 14 is an exploded perspective view for explaining in detail a magnetic shield illustrated in FIG. 4;
FIG. 15 is a developed view of an electric shield;
FIG. 16 is a developed view of the electric shield in which the shape of a detection surface cut is different from that in FIG. 15;
FIG. 17 is a central longitudinal sectional view of the first coil and the ferrite core;
FIG. 18 is a graph illustrating a result of electromagnetic field simulation;
FIG. 19 is a magnetic flux diagram in a case where the shaft body of the ferrite core is thin; and
FIG. 20 is a magnetic flux diagram in a case where the shaft body of the ferrite core is not thin.

### DETAILED DESCRIPTION

Hereinafter, embodiments of the invention will be described with reference to the drawings. Note that, in the drawings, the same or corresponding portions are denoted by the same reference numerals, and the description thereof will not be repeated. In the following description, terms meaning a position or a direction such as "upper", "lower", "left", and "right" may be used. These terms are used for convenience to facilitate understanding of the embodiments, and are not related to the direction in which they are actually implemented unless otherwise expressly stated.

Hereinafter, a proximity sensor according to an embodiment of the invention will be described with reference to the drawings.

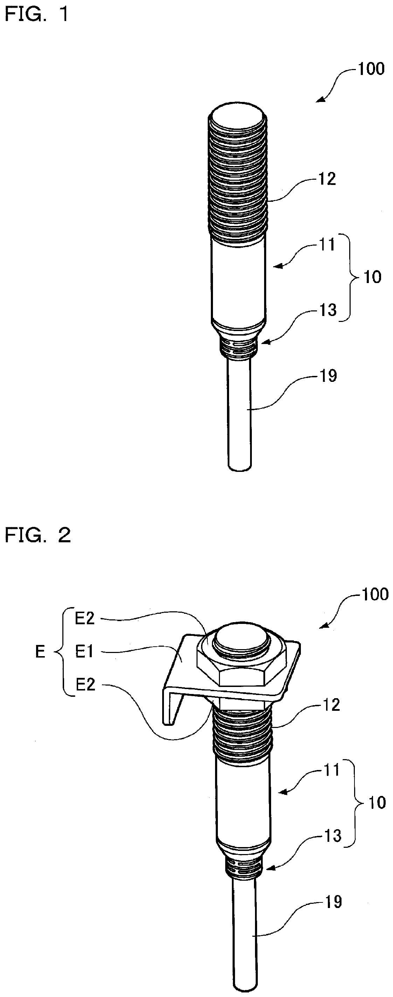

First, a situation in which a proximity sensor 100 is used will be described with reference to FIGS. 1 and 2. FIG. 1 is an external view of the proximity sensor 100. FIG. 2 is an external view of the proximity sensor 100 in a used state.

As illustrated in FIG. 1, the proximity sensor 100 has a shape (shield type) that can be fixed by a nut or the like by forming an outer screw 12 on a side surface. As illustrated in FIG. 2, the proximity sensor 100 in a used state is fixed to a mounting bracket E1 with a double nut E2, for example. That is, the proximity sensor 100 is embedded in the mounting bracket E1 and the double nut E2. In this state, the proximity sensor 100 detects an embedded metal E such as the mounting bracket E1 and the double nut E2 which are not originally detected. Therefore, the proximity sensor 100 according to the embodiment of the invention is configured to suppress the influence of the embedded metal E in order to sufficiently extend the detection distance.

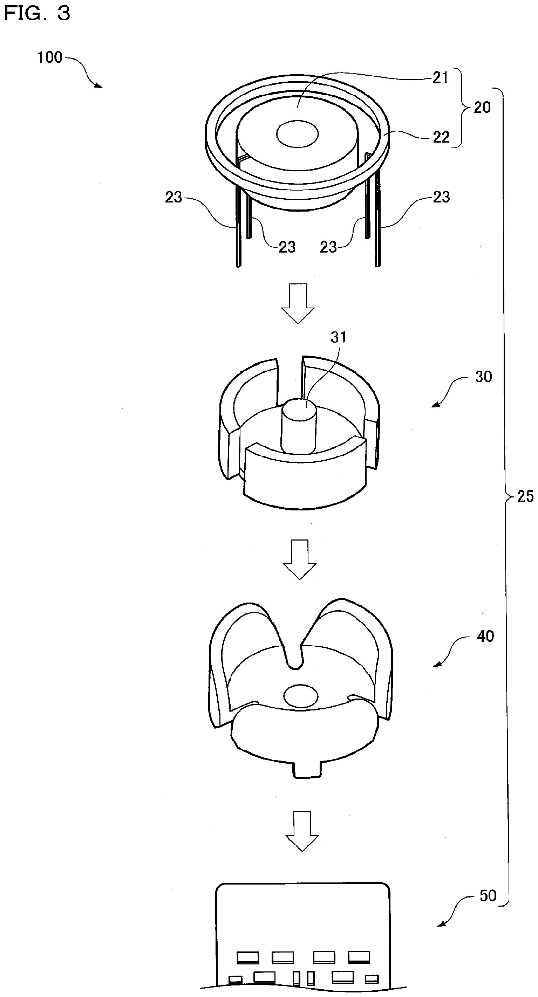

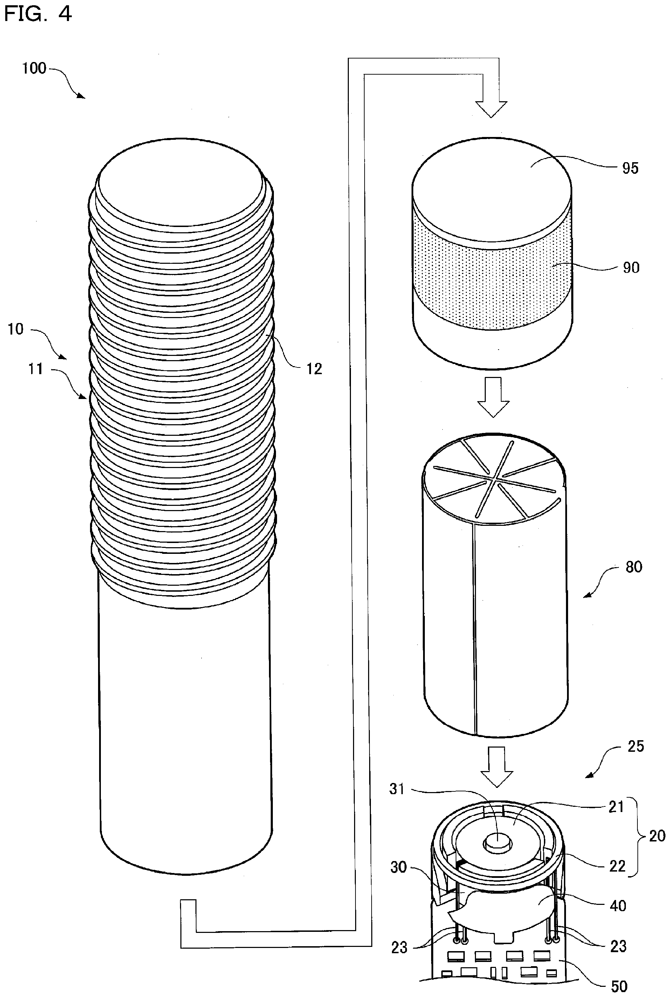

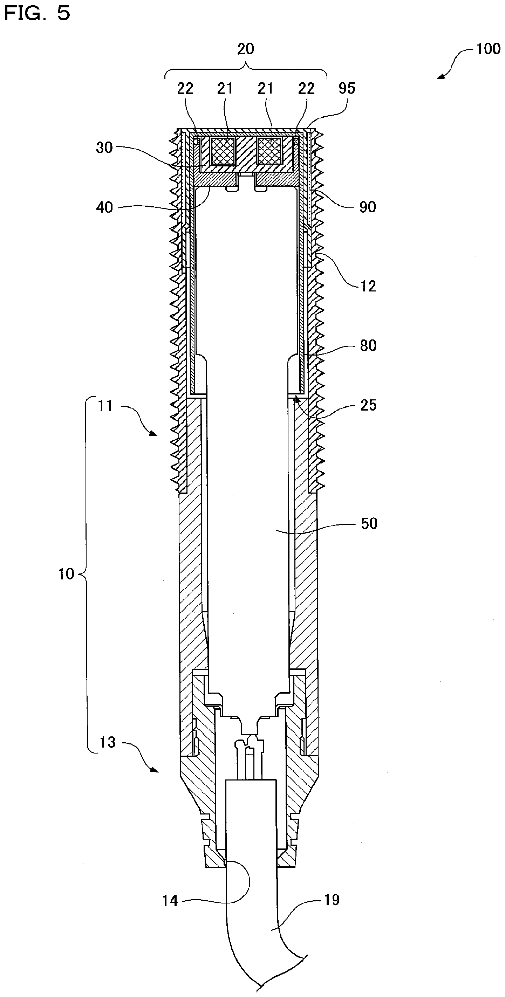

Hereinafter, a main component configuration of the proximity sensor 100 will be described with reference to FIGS. 3 to 5. FIG. 3 is an exploded perspective view from a coil 20 to a substrate 50 constituting the proximity sensor 100. FIG. 4 is an exploded perspective view of components housed in a casing 10 of the proximity sensor 100. FIG. 5 is a central longitudinal sectional view of the proximity sensor 100.

As illustrated in FIG. 3, the proximity sensor 100 includes a coil 20, a ferrite core 30, a core holder 40, and a substrate 50. Hereinafter, the coil 20, the ferrite core 30, the core holder 40, and the substrate 50 may be collectively referred to as a sensor unit 25.

The coil 20 generates a magnetic field by an excitation current. The ferrite core 30 guides the magnetic field generated from the coil 20. The core holder 40 holds the ferrite core 30. The substrate 50 is electrically connected to the coil 20 via a lead wire 23.

As illustrated in FIGS. 3 and 4, a plurality of (four in the illustrated example) lead wires 23 are provided from the coil 20. All of the plurality of lead wires 23 are disposed at positions that are not point-symmetric with respect to the axis of the coil 20. That is, all of the plurality of lead wires 23 are disposed at positions not facing the axis of the coil 20 at 180°.

With this arrangement, as illustrated in FIG. 4, the plurality of lead wires 23 can be collectively soldered to one surface of the substrate 50. Therefore, the proximity sensor 100 can be easily manufactured by collectively soldering the plurality of lead wires 23 on one surface of the substrate 50. The plurality of lead wires 23 reach the substrate 50 from the coil 20 through the gap between the ferrite core 30 and the core holder 40.

In addition to the sensor unit 25, the proximity sensor 100 further includes an electric shield 80, a magnetic shield 90, and a casing 10.

The electric shield 80 covers the sensor unit 25. The electric shield 80 completely covers the coil 20, the ferrite core 30, and the core holder 40 in the sensor unit 25, and partially covers the substrate 50.

The magnetic shield 90 covers the sensor unit 25 together with the electric shield 80. The magnetic shield 90 partially covers the electric shield 80. The magnetic shield 90 completely covers the coil 20, the ferrite core 30, and the core holder 40 in the sensor unit 25, and partially covers the substrate 50.

The casing 10 has a casing body 11 in which the outer screw 12 is formed. As illustrated in FIGS. 4 and 5, the casing body 11 completely covers the magnetic shield 90, the electric shield 80, and the sensor unit 25. As illustrated in FIG. 5, the casing 10 further includes a casing base end 13 in which a cable attachment port 14 is formed. The casing base end 13 is inserted into the casing body 11 from the substrate 50 side.

The proximity sensor 100 further includes a cable 19. The cable 19 is electrically connected to the substrate 50. The cable 19 extends from the inside to the outside of the casing 10 through the cable attachment port 14 of the casing base end 13.

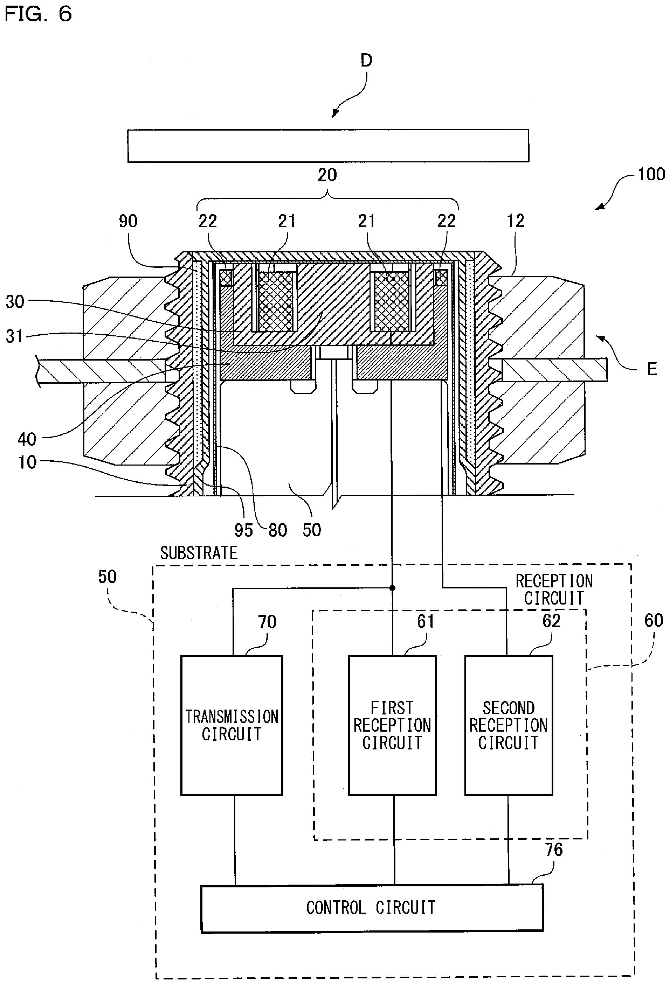

Hereinafter, a main circuit configuration of the proximity sensor 100 will be described with reference to FIG. 6. FIG. 6 is a block diagram for explaining a main circuit configuration of the proximity sensor 100.

As illustrated in FIG. 6, the proximity sensor 100 further includes a transmission circuit 70, a reception circuit 60, and a control circuit 76 as main circuit configurations.

The transmission circuit 70 periodically applies a pulsed excitation current to the coil 20. The coil 20 generates a magnetic field by periodically flowing a pulsed excitation current. The coil 20 includes a first coil 21 and a second coil 22. The second coil 22 is disposed outside the first coil 21 in the radial direction. The second coil 22 may be disposed concentrically with the first coil 21. In the present example, "disposed concentrically" indicates an arrangement relationship in which the circles are not limited to the objects on the same plane, and thus, in a case where the second coil 22 is disposed concentrically with respect to the first coil 21, the second coil 22 may be disposed on the side where a detection object D is detected (or the opposite side) with respect to the first coil 21.

In a case where the detection object D is within the detection range, an eddy current is generated in the detection object D by the magnetic field generated from the coil 20. A magnetic field is generated from the detection object D by the eddy current of the detection object D. Here, since the excitation current flowing through the coil 20 is pulsed, the magnetic field generated from the coil 20 is rapidly weakened. Therefore, the eddy current of the detection object D also weakens, and accordingly, the magnetic field generated from the detection object D also weakens. In order to prevent the weakening of the magnetic field generated from the detection object D, a voltage or a current is generated in the coil 20.

The reception circuit 60 detects a voltage or a current generated in each of the first coil 21 and the second coil 22. Since the first coil 21 and the second coil 22 have different arrangements, characteristics of the generated voltage or current are also different. By detecting voltages or currents having different characteristics, an arithmetic operation for suppressing the influence of the embedded metal E becomes efficient. Note that the reception circuit 60 may be configured to detect a voltage or a current generated in at least one of the first coil 21 and the second coil 22.

The control circuit 76 detects the detection object D on the basis of the change in the voltage or the current detected by the reception circuit 60. Preferably, the control circuit 76 detects the detection object D on the basis of a change in the voltage or the current generated in each of the first coil 21 and the second coil 22. As a result, the proximity sensor 100 can sufficiently extend the detection distance by suppressing the influence of the embedded metal E.

In the example illustrated in FIG. 6, the first coil 21 generates a magnetic field by periodically flowing a pulsed excitation current from the transmission circuit 70. In the present embodiment, only the first coil 21 generates the magnetic field by the excitation current, but the coil 20 that generates the magnetic field by the excitation current may be only the second coil 22, or may be both the first coil 21 and the second coil 22. In a case where an excitation current is applied to only one of the first coil 21 and the second coil 22 to generate a magnetic field, it is preferable to apply an excitation current only to the first coil 21 to generate a magnetic field. As described above, the detection result by the first coil 21 is different from the detection result by the second coil 22, but in order to extend the detection distance, it is preferable that both detection results are easily affected by the detection object D. In a case where the magnetic field generated from the coil 20 is directed to a range in which the detection object D can be located, that is, a detection range, the detection result by the coil 20 is easily affected by the detection object D. The coil 20 through which the excitation current flows is preferably a coil wound close to a shaft body 31 of the ferrite core 30 to generate a magnetic field by causing the excitation current to flow through the first coil 21 since the generated magnetic field is easily directed to the detection range. In addition, in a case where an excitation current is caused to flow through both the first coil 21 and the second coil 22 to generate a magnetic field, for example, by directing the direction of the magnetic field of the first coil 21 to the detection object D and directing the direction of the magnetic field of the second coil 22 to the embedded metal E, it is possible to obtain a detection result in which the magnetic field of the first coil 21 and the magnetic field of the second coil 22 interfere with each other and the influence of the embedded metal E is reduced.

In the example illustrated in FIG. 6, the transmission circuit 70, the reception circuit 60, and the control circuit 76 are provided on the substrate 50. By providing the transmission circuit 70, the reception circuit 60, and the control circuit 76 on the substrate 50, the circuit configuration is stabilized. The transmission circuit 70, the reception circuit 60, and the control circuit 76 are not limited to being provided on the substrate 50. For example, the transmission circuit 70, the reception circuit 60, and the control circuit 76 may be provided in different members. Furthermore, any one or two of the transmission circuit 70, the reception circuit 60, and the control circuit 76 may be provided on the substrate 50, and the other circuits may be provided on another substrate or member (a substrate or member disposed inside or outside the casing 10).

The reception circuit 60 includes a first reception circuit 61 and a second reception circuit 62. The first reception circuit 61 detects a voltage or a current generated in the first coil 21. The second reception circuit 62 detects a voltage or a current generated in the second coil 22. Hereinafter, the temporal change of the voltage or the current detected by the reception circuit 60 may be referred to as a reception waveform. The temporal changes of the voltage or the current detected by the first reception circuit 61 and the second reception circuit 62 may be referred to as a first reception waveform and a second reception waveform, respectively.

Since the reception circuit 60 includes the first reception circuit 61 and the second reception circuit 62, it is not necessary to switch the reception circuit 60 between the case of detecting the voltage or the current generated in the first coil 21 and the case of detecting the voltage or the current generated in the second coil 22. That is, since the reception circuit 60 includes the first reception circuit 61 and the second reception circuit 62, it is possible to simultaneously detect a voltage or a current generated in the first coil 21 and a voltage or a current generated in the second coil 22. Therefore, the proximity sensor 100 can sufficiently extend the detection distance by improving the detection accuracy.

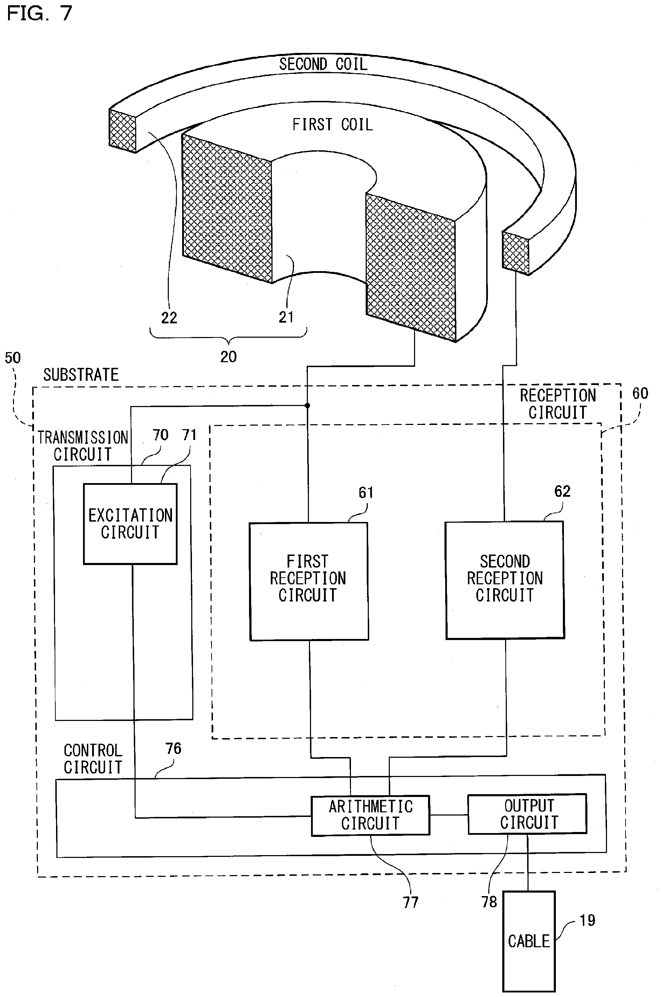

Hereinafter, details of the transmission circuit 70, the reception circuit 60, and the control circuit 76 will be described with reference to FIG. 7. FIG. 7 is a block diagram for explaining a main circuit configuration of the proximity sensor 100 in detail.

The transmission circuit 70 includes an excitation circuit 71. The excitation circuit 71 generates a pulsed excitation current on the basis of a signal from the control circuit 76 and causes the pulsed excitation current to flow to the first coil 21.

The control circuit 76 includes an arithmetic circuit 77 and an output circuit 78. The arithmetic circuit 77 performs an arithmetic operation for detecting the detection object D on the basis of at least one of the first reception waveform and the second reception waveform. The arithmetic circuit 77 performs an arithmetic operation on the basis of both the first reception waveform and the second reception waveform. The output circuit 78 outputs the result of the arithmetic operation by the arithmetic circuit 77 to the outside via the cable 19. The arithmetic circuit 77 may be configured to perform an arithmetic operation for detecting the detection object D on the basis of at least one of the first reception waveform and the second reception waveform, and the response speed increases in a case where the arithmetic operation is performed on the basis of only one of the first reception waveform and the second reception waveform.

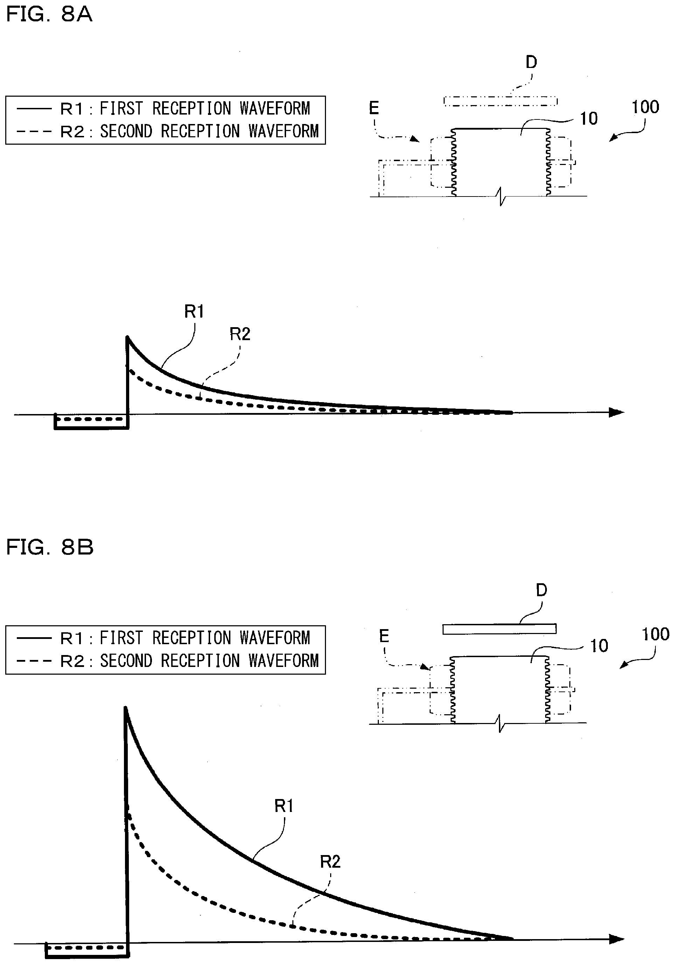

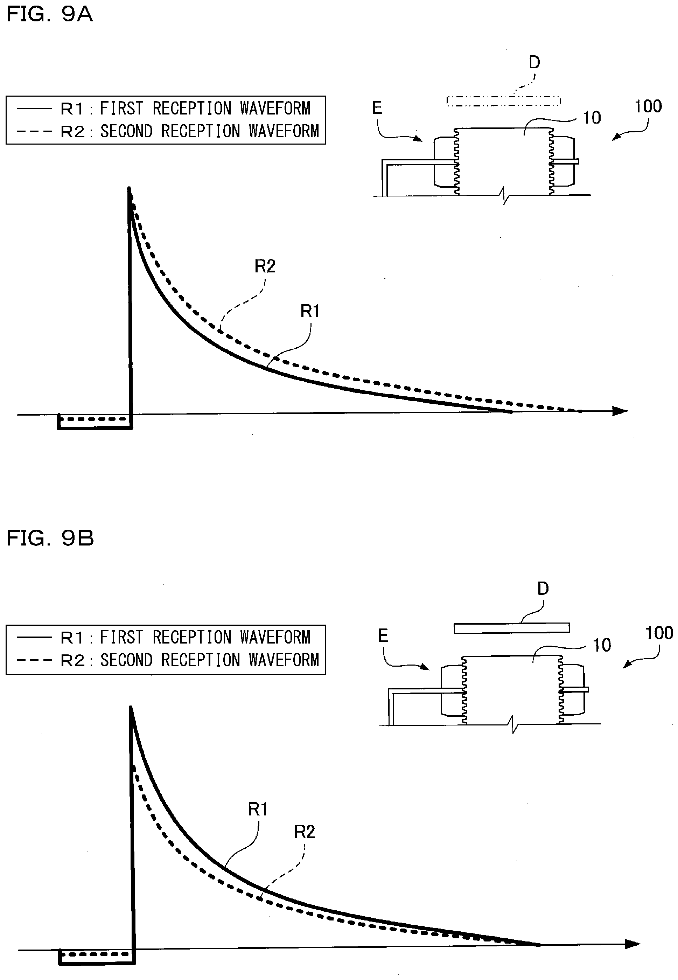

Hereinafter, images of the first reception waveform and the second reception waveform will be described with reference to FIGS. 8A, 8B, 9A, and 9B. In FIGS. 8A to 9B, the first reception waveform is indicated by symbol R1, and the second reception waveform is indicated by symbol R2.

FIG. 8A is a graph illustrating an image of a reception waveform in a case where there is no embedded metal E and the detection object D is not within the detection range. FIG. 8B is a graph illustrating an image of a reception waveform in a case where there is no embedded metal E and the detection object D is within the detection range. FIG. 9A is a graph illustrating an image of a reception waveform in a case where the embedded metal E is present and the detection object D is not within the detection range. FIG. 9B is a graph illustrating an image of the reception waveform in a case where the embedded metal E is present and the detection object D is within the detection range. In the graphs of FIGS. 8A to 9B, the horizontal axis represents time, and the vertical axis represents the signal intensity of the reception waveform.

FIGS. 8A and 8B are graphs when there is no embedded metal E. As illustrated in FIG. 8A, in a case where the detection object D is not within the detection range, the proximity sensor 100 itself is slightly detected, so that the first reception waveform and the second reception waveform reflecting the detection appear. As illustrated in FIG. 8B, in a case where the detection object D is within the detection range, the detection object D is detected, and thus, both the change amount of the first reception waveform and the change amount of the second reception waveform are larger than those in a case where the detection object D is not within the detection range. In particular, the first reception waveform that is more susceptible to the detection object D than the second reception waveform has a larger change amount than the second reception waveform.

FIGS. 9A and 9B are graphs in a case where the embedded metal E is present. As illustrated in FIG. 9A, in a case where the detection object D is not within the detection range, the embedded metal E is detected, so that both the change amount of the first reception waveform and the change amount of the second reception waveform are larger than those in a case where the embedded metal E in FIG. 8A is not present and the detection object D is not within the detection range. In particular, the second reception waveform that is more susceptible to the embedded metal E than the first reception waveform has a larger change amount than the first reception waveform. As illustrated in FIG. 9B, in a case where the detection object D is within the detection range, the detection object D is also detected, so that both the change amount of the first reception waveform and the change amount of the second reception waveform are larger than those in the case where the detection object D is not within the detection range. In particular, the first reception waveform that is more susceptible to the detection object D than the second reception waveform has a larger difference in the change amount with respect to the change amount in a case where the detection object D is not within the detection range than the second reception waveform.

Although the first reception waveform is more susceptible to the detection object D than the second reception waveform, the difference in the change amount of the waveform depending on whether or not the detection object D is within the detection range is small in a case where the embedded metal E is present as illustrated in FIGS. 9A and 9B as compared with the case where the embedded metal E is not present as illustrated in FIGS. 8A and 8B. In particular, the longer the distance between the detection object D and the coil 20, the smaller the difference in the change amount of the waveform caused by whether or not the detection object D is within the detection range. However, as illustrated in FIGS. 8A to 9B, the first reception waveform is more susceptible to the detection object D than the second reception waveform, the second reception waveform is more susceptible to the embedded metal E than the first reception waveform, and the second reception waveform has a difference in change amount with a tendency different from the first reception waveform. More specifically, in the second reception waveform, the difference in the change amount of the waveform due to the presence or absence of the detection object D within the detection range is smaller than the first reception waveform, and the difference in the change amount of the waveform due to the presence or absence of the embedded metal E is larger than the first reception waveform. Therefore, the detection object D is efficiently detected while the influence of the embedded metal E is suppressed by the arithmetic operation based on both the first reception waveform and the second reception waveform.

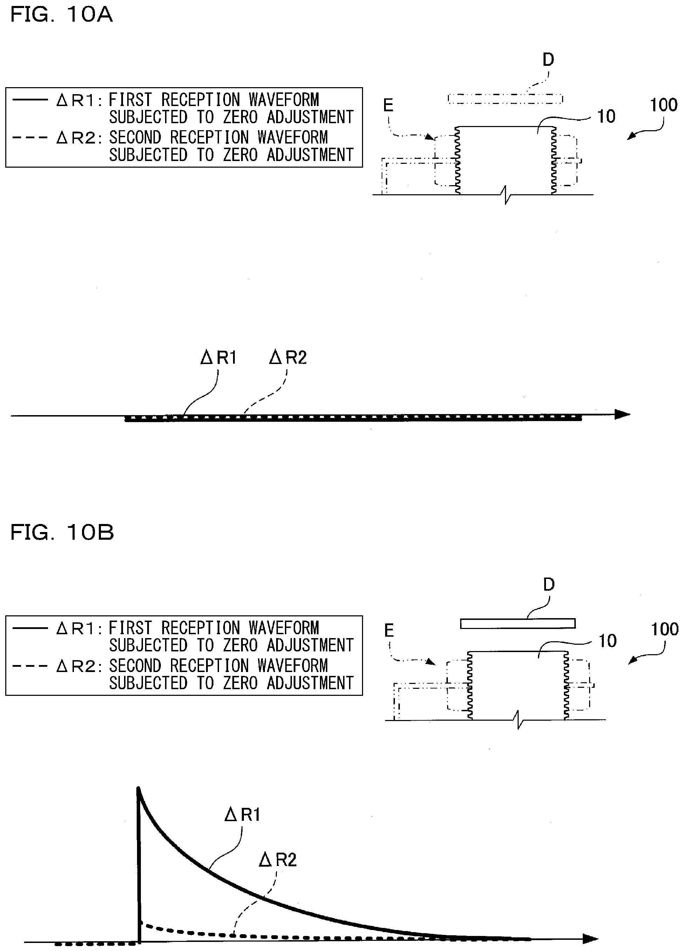

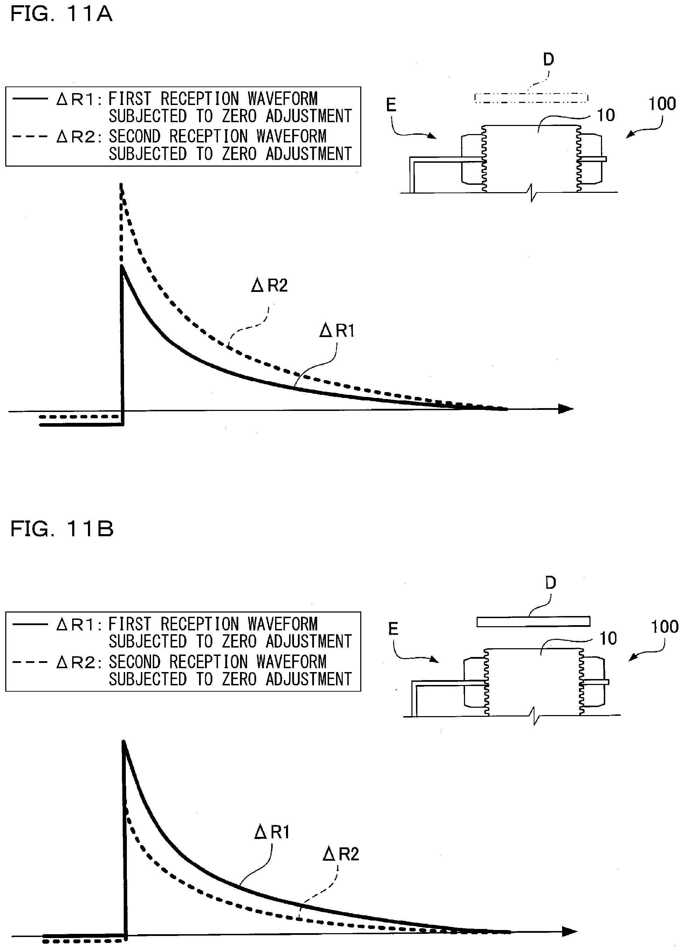

Hereinafter, images of the first reception waveform and the second reception waveform subjected to the zero adjustment will be described with reference to FIGS. 10A, 10B, 11A, and 11B. In FIGS. 10A to 11B, the first reception waveform subjected to the zero adjustment is indicated by a symbol ΔR1, and the second reception waveform subjected to the zero adjustment is indicated by a symbol ΔR2.

FIG. 10A is a graph illustrating an image of a reception waveform adjusted to 0 in a case where there is no embedded metal E and the detection object D is not within the detection range. FIG. 10B is a graph illustrating an image of the reception waveform adjusted to 0 in a case where there is no embedded metal E and the detection object D is within the detection range. FIG. 11A is a graph illustrating an image of a reception waveform adjusted to 0 in a case where the embedded metal E is present and the detection object D is not within the detection range. FIG. 11B is a graph illustrating an image of the reception waveform subjected to the zero adjustment when the embedded metal E is present and the detection object D is within the detection range. In the graphs of FIGS. 10A to 11B, the horizontal axis represents time, and the vertical axis represents the signal intensity of the reception waveform.

FIGS. 10A and 10B are graphs when there is no embedded metal E. As illustrated in FIG. 10A, in a case where the detection object D is not within the detection range, the measurement value is calibrated to be 0 (zero adjustment), so that the zero-adjusted first reception waveform and second reception waveform do not appear. As illustrated in FIG. 10B, in a case where the detection object D is within the detection range, the detection object D is detected, so that both the change amount of the first reception waveform subjected to the zero adjustment and the change amount of the second reception waveform subjected to the zero adjustment increase. In particular, the first reception waveform subjected to the zero adjustment, which is more susceptible to the influence of the detection object D than the second reception waveform subjected to the zero adjustment, has a larger change amount than the second reception waveform subjected to the zero adjustment.

FIGS. 11A and 11B are graphs in a case where embedded metal E is present. As illustrated in FIG. 11A, in a case where the detection object D is not within the detection range, the embedded metal E is detected, so that both the change amount of the first reception waveform subjected to the zero adjustment and the change amount of the second reception waveform subjected to the zero adjustment increase. In particular, the second reception waveform subjected to the zero adjustment, which is more susceptible to the influence of the embedded metal E than the first reception waveform subjected to the zero adjustment, has a larger change amount than the first reception waveform subjected to the zero adjustment. As illustrated in FIG. 11B, in a case where the detection object D is within the detection range, the detection object D is also detected, so that both the change amount of the first reception waveform subjected to the zero adjustment and the change amount of the second reception waveform subjected to the zero adjustment are larger than those in a case where the detection object D is not within the detection range. In particular, in the first reception waveform subjected to the zero adjustment, which is more susceptible to the influence of the detection object D than the second reception waveform subjected to the zero adjustment, the difference in the change amount with respect to the change amount in a case where the detection object D is not within the detection range is larger than the second reception waveform subjected to the zero adjustment.

As illustrated in FIGS. 10A to 11B, the first reception waveform subjected to the zero adjustment is susceptible to the detection object D, and the second reception waveform subjected to the zero adjustment is susceptible to the embedded metal E. Therefore, the detection object D is efficiently detected while the influence of the embedded metal E is suppressed by the arithmetic operation based on both the first reception waveform and the second reception waveform which are subjected to the zero adjustment.

This arithmetic operation is, for example, a difference between the first reception waveform and the second reception waveform subjected to the zero adjustment. The difference is subtraction (ΔR1 - ΔR2) of the second reception waveform subjected to the zero adjustment from the first reception waveform subjected to the zero adjustment.

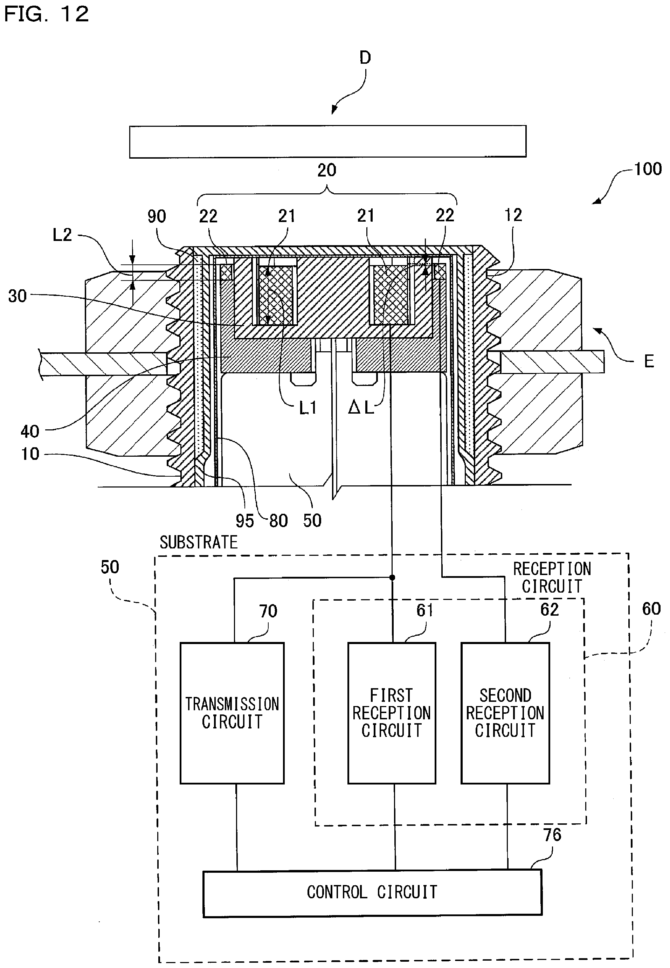

Hereinafter, the size and arrangement of the first coil 21 and the second coil 22 will be described in detail with reference to FIG. 12. FIG. 12 is a view illustrating sizes and arrangements of the first coil 21 and the second coil 22.

As illustrated in FIG. 12, the radial direction of the first coil 21 and the radial direction of the second coil 22 are the same direction (left-right direction in FIG. 12). Therefore, hereinafter, the radial direction of the first coil 21 or the second coil 22 may be simply referred to as a radial direction.

The axial direction of the first coil 21 and the axial direction of the second coil 22 are the same direction (up-down direction in FIG. 12). Therefore, hereinafter, the axial direction of the first coil 21 or the second coil 22 may be simply referred to as an axial direction. The radial direction (left-right direction in FIG. 12) and the axial direction (up-down direction in FIG. 12) are orthogonal to each other.

Hereinafter, in the axial direction, the side on which the detection object D is detected (the upper side in FIG. 12) may be referred to as a distal end side, and the side opposite to the distal end side (the lower side in FIG. 12) may be referred to as a proximal end side.

The second coil 22 is shorter than the first coil 21 in a direction (axial direction) orthogonal to the radial direction thereof. That is, an axial length L2 of the second coil 22 is shorter than an axial length L1 of the first coil 21 (L2 < L1). Since the axial length L2 of the second coil 22 is shorter than the axial length L1 of the first coil 21, the magnetic flux lines passing through the embedded metal E are reduced. Therefore, the proximity sensor 100 can sufficiently extend the detection distance by suppressing the influence of the embedded metal E. In addition, with such a configuration, the second coil 22 has a lower sensitivity to the magnetic flux with respect to the first coil 21. From the detection result of the second coil 22, it is preferable to reduce the influence of the magnetic flux passing through both the detection object D and the embedded metal E. By reducing the sensitivity of the second coil 22 to the magnetic flux with respect to the first coil 21, the influence of the magnetic flux passing through both the detection object D and the embedded metal E is reduced.

The second coil 22 is located on the side (distal end side) where the detection object D is detected with respect to the first coil 21. Specifically, the second coil 22 is located on the distal end side of the first coil 21 by a predetermined distance ΔL. Since the second coil 22 is located on the distal end side of the first coil 21, the magnetic flux lines passing through the embedded metal E are reduced. Therefore, the proximity sensor 100 can sufficiently extend the detection distance by suppressing the influence of the embedded metal E.

The second coil 22 is preferably located on the distal end side. This is because the magnetic flux lines passing through the embedded metal E decrease as the second coil 22 is located on the more distal end side. Therefore, it is more preferable that the second coil 22 abuts on a member on the most distal end side of the proximity sensor 100.

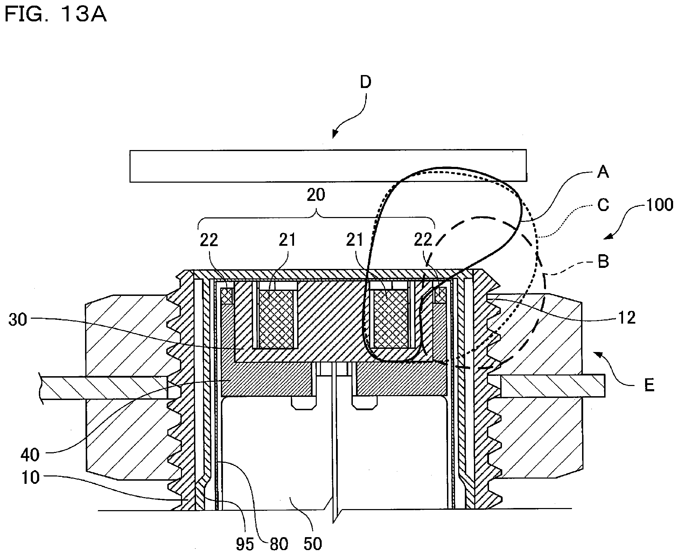

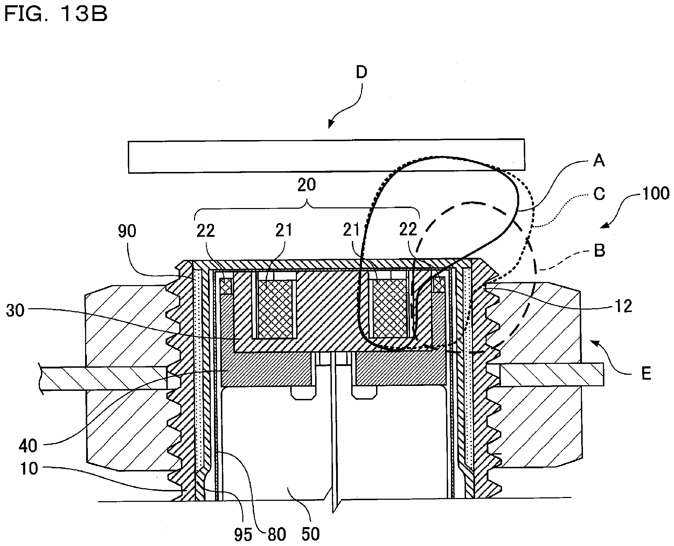

Hereinafter, a magnetic field and magnetic flux lines thereof will be described with reference to FIGS. 13A and 13B. FIG. 13A is a central longitudinal sectional view in a state in which the influence of the embedded metal E is slightly suppressed. FIG. 13B is a central longitudinal sectional view in a state where the influence of the embedded metal E is further suppressed.

As illustrated in FIGS. 13A and 13B, the core holder 40 holds the ferrite core 30 and positions the second coil 22. When the core holder 40 positions the second coil 22, the arrangement of the second coil 22 is stabilized regardless of the ferrite core 30. As the arrangement of the second coil 22 is stabilized, the second reception waveform is stably detected. Therefore, the proximity sensor 100 can sufficiently extend the detection distance by suppressing the influence of the embedded metal E.

The core holder 40 preferably has a structure for fixing the substrate 50. With the structure in which the core holder 40 fixes the substrate 50, the positioning accuracy between the substrate 50 and the coil 20 is enhanced, and the proximity sensor 100 can be easily manufactured in a space-saving manner. The core holder 40 is made of resin, for example.

Next, the magnetic flux lines of the magnetic field received by the coil 20 will be described while comparing FIGS. 13A and 13B.

In FIGS. 13A and 13B, the magnetic flux line received only by the first coil 21 is indicated by a thick line of a symbol A, the magnetic flux line received only by the second coil 22 is indicated by a broken line of a symbol B, and the magnetic flux lines received by both the first coil 21 and the second coil 22 are indicated by a dotted line of a symbol C.

The magnetic flux line (thick line: symbol A) received only by the first coil 21 has a high rate of generating a reception waveform based on the detection object D. The magnetic flux line (broken line: symbol B) received only by the second coil 22 has a high rate of generating a reception waveform based on the embedded metal E. The magnetic flux lines (dotted line: symbol C) received by both the first coil 21 and the second coil 22 have a high rate of generating a reception waveform based on both the detection object D and the embedded metal E.

Therefore, by reducing the magnetic flux lines (dotted line: symbol C) received by both the first coil 21 and the second coil 22, the respective ratios of the reception waveform based on the detection object D and the reception waveform based on the embedded metal E relatively increase. When the ratio between the reception waveform based on the detection object D and the reception waveform based on the embedded metal E increases, the reception waveform based on the embedded metal E can be easily grasped, leading to reduction of the influence of the embedded metal E.

As compared with FIG. 13A, in FIG. 13B, the magnetic flux lines (dotted line: symbol C) received by both the first coil 21 and the second coil 22 form a path avoiding the embedded metal E. Therefore, in FIG. 13B, the magnetic flux lines (dotted line: symbol C) received by both the first coil 21 and the second coil 22 decrease more than that in FIG. 13A. In order to achieve the state illustrated in FIG. 13B, the magnetic shield 90 and the ferrite core 30 are appropriately provided.

As illustrated in FIG. 13B, by appropriately arranging the magnetic shield 90, the magnetic flux lines (dotted line: symbol C) received by both the first coil 21 and the second coil 22 form a path that further avoid the embedded metal E. This is because the magnetic shield 90 guides the magnetic flux lines with relative magnetic permeability of a certain degree or more.

By forming the ferrite core 30 into an appropriate shape, the magnetic flux lines (dotted line: symbol C) received by both the first coil 21 and the second coil 22 form a path that further avoids the embedded metal E. This is because the shape of the ferrite core 30 causes the magnetic flux lines to further face the distal end side.

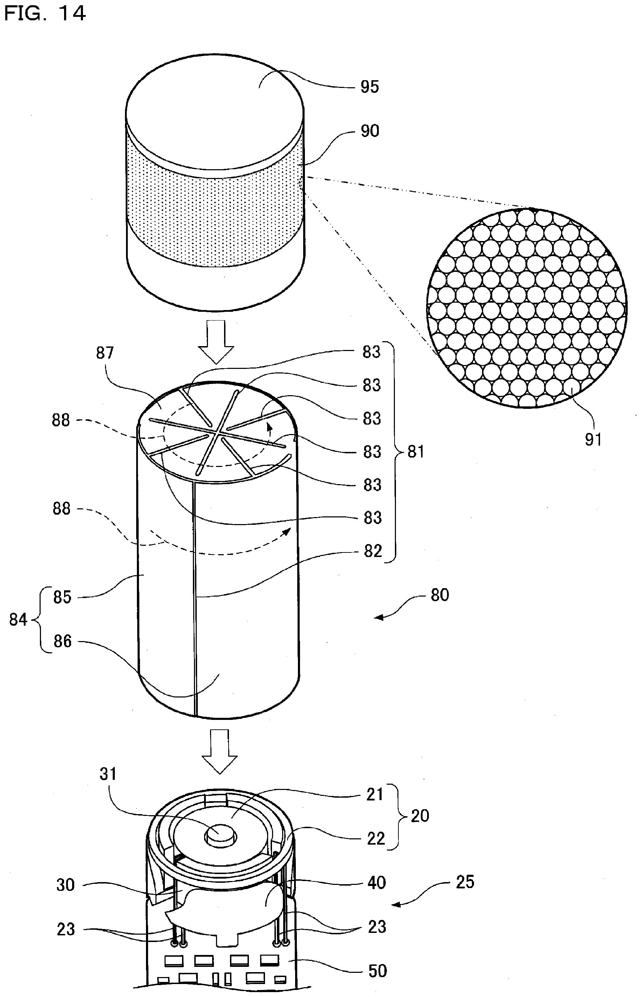

Hereinafter, the magnetic shield 90 will be described in detail with reference to FIGS. 13B and 14. FIG. 14 is an exploded perspective view for explaining the magnetic shield 90 illustrated in FIG. 4 in detail.

As illustrated in FIG. 13B, the magnetic shield 90 is disposed outside the second coil 22 in the radial direction. With this arrangement, the magnetic flux lines (dotted line: symbol C) received by both the first coil 21 and the second coil 22 are guided along the magnetic shield 90, so that a path that further avoids the embedded metal E is obtained. Therefore, the proximity sensor 100 can sufficiently extend the detection distance by suppressing the influence of the embedded metal E.

In the proximity sensor 100, the magnetic shield 90 is more preferable toward the outer side in the radial direction. This is because the magnetic flux lines (dotted line: symbol C) received by both the first coil 21 and the second coil 22 are guided in a direction to further avoid the embedded metal E. For example, the magnetic shield 90 is disposed outside the electric shield 80 (and inside the casing 10) in the radial direction. The magnetic shield 90 may constitute the casing 10.

As illustrated in FIG. 14, the magnetic shield 90 includes a sheet member kneaded with ferromagnetic powder 91. Since the magnetic shield 90 is formed of a sheet member kneaded with the ferromagnetic powder 91, the magnetic shield has a relative magnetic permeability higher (to some extent or more) than air and a low electric conductivity. The magnetic shield 90 appropriately guides the magnetic flux lines with relative magnetic permeability higher than air. The magnetic shield 90 has a low electrical conductivity, so that an eddy current loop in the magnetic shield 90 can be suppressed without performing insulation treatment. By suppressing the eddy current loop, noise to the reception waveform is suppressed. Therefore, the proximity sensor 100 including such a magnetic shield 90 can sufficiently extend the detection distance by improving the detection accuracy.

The ferromagnetic powder 91 constituting the magnetic shield 90 is, for example, iron powder. Since the magnetic shield 90 is formed of a sheet member kneaded with iron powder, the magnetic shield has a relatively high relative magnetic permeability (about 200 to 300). The sheet member kneaded with iron powder is, for example, an electromagnetic wave absorbing sheet. In this example, a sheet member kneaded with the ferromagnetic powder 91 is used as the magnetic shield 90, but the entire magnetic shield 90 may be an amorphous ferromagnetic member. For example, it may be amorphous.

Note that a permalloy sheet, a cobalt sheet, or the like is not suitable as the magnetic shield 90. This is because a permalloy sheet, a cobalt sheet, or the like has a high relative magnetic permeability (about 1000 to several tens of thousands) but has a high electrical conductivity. The high electrical conductivity leads to the generation of the eddy current loop.

The magnetic shield 90 is wound around an outer periphery of a resin cap 95 having a bottomed cylindrical shape. The resin cap 95 has a function of protecting a member accommodated inside the resin cap 95. The magnetic shield 90 is wound around the outer periphery of the resin cap 95, whereby the arrangement on the outer side in the radial direction is stabilized. Instead of the resin cap 95 made of resin, a cap other than resin may be used. The magnetic shield 90 is disposed outside the cap regardless of whether or not the cap is made of resin.

Hereinafter, details of the electric shield 80 will be described with reference to FIGS. 14 to 16. The electric shield 80 is a bottomed cylindrical metal body that protects the coil 20 and the ferrite core 30 from external noise.

As illustrated in FIG. 14, the electric shield 80 is disposed outside the second coil 22 in the radial direction. A cut 81 (slit) is formed in the electric shield 80. The cut 81 is transverse to a direction 88 around the axis of the electric shield 80. Specifically, the longitudinal direction of the cut 81 intersects (preferably is orthogonal to) the direction 88 around the axis.

By the cut 81 intersecting the direction 88 around the axis of the electric shield 80, a loop of an eddy current which is a current around the axis is suppressed in the electric shield 80. By suppressing the eddy current loop, noise to the reception waveform is suppressed. Therefore, the proximity sensor 100 including such an electric shield 80 can sufficiently extend the detection distance by improving the detection accuracy.

The electric shield 80 includes a peripheral portion 84 and a detection surface portion 87. The peripheral portion 84 covers the second coil 22 from the outside in the radial direction. The detection surface portion 87 is located on the side where the detection object D is detected. The detection surface portion 87 closes the distal end side which is one end of the peripheral portion 84.

The cut 81 has a peripheral cut 82 and a detection surface cut 83. The peripheral cut 82 is formed in the peripheral portion 84. The detection surface cut 83 is formed in the detection surface portion 87.

By the peripheral cut 82, an eddy current loop is suppressed in the peripheral portion 84. The peripheral cut 82 facilitates the manufacture of the electric shield 80. The detection surface cut 83 efficiently suppresses the eddy current loop in the detection surface portion 87.

The electric shield 80 has a sheet metal configuration. That is, the electric shield 80 is obtained by bending a thin metal plate. Since the electric shield 80 has the sheet metal configuration, the shape is stabilized even if the strength is reduced due to the cut 81.

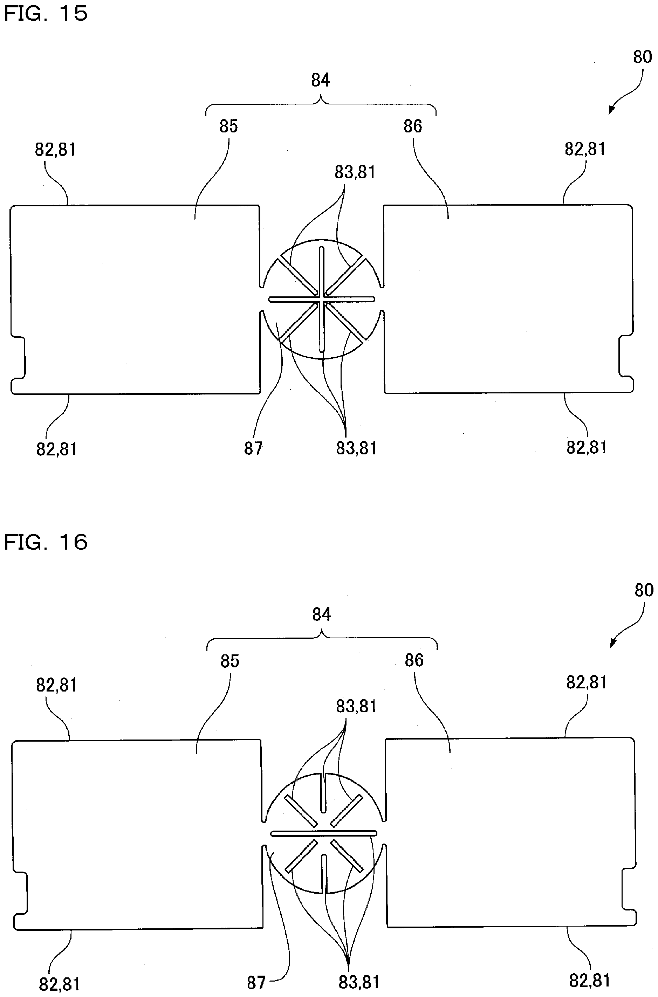

The thin metal plate before being bent as the electric shield 80 is illustrated in FIGS. 15 and 16. FIG. 15 is a developed view of the electric shield 80. FIG. 16 is a developed view of the electric shield 80 in which the shape of the detection surface cut 83 is different from that in FIG. 15.

As illustrated in FIGS. 15 and 16, the thin metal plate before being bent as the electric shield 80 is punched out. The thin metal plate is stamped such that the cuts 81 are also formed simultaneously. The electric shield 80 has a bottomed cylindrical three-dimensional shape illustrated in FIG. 14 by pressing the punched thin metal plate. That is, the electric shield 80 is a press-molded product of a punched thin metal plate. The shape of such an electric shield 80 is further stabilized even if the strength is reduced by the cut 81. The thin metal plate constituting the electric shield 80 is, for example, copper foil or brass foil.

The peripheral portion 84 has a left half peripheral portion 85 and a right half peripheral portion 86. The left half peripheral portion 85 and the right half peripheral portion 86 are connected to the detection surface portion 87 from the left side and the right side, respectively. The left half peripheral portion 85 and the right half peripheral portion 86 are bent so as to be perpendicular to the detection surface portion 87. Further, the left half peripheral portion 85 and the right half peripheral portion 86 are subjected to roll bending and pressing such that the edge on the side close to the detection surface portion 87 is along the edge of the detection surface portion 87.

The peripheral cut 82 is a gap between the left half peripheral portion 85 and the right half peripheral portion 86. The detection surface cut 83 is a radial gap from the center of the detection surface portion 87.

In the example illustrated in FIG. 15, in the clock position in which the upward direction in FIG. 15 is 0:00, the radial gaps extending in the directions of 0:00, 3:00, 6:00, and 9:00 do not reach the edge of the detection surface portion 87 while passing through the center of the detection surface portion 87. The radial gaps extending in the directions between 1:00 and 2:00, between 4:00 and 5:00, between 7:00 and 8:00, and between 10:00 and 11:00 do not pass through the center of the detection surface portion 87 but reach the edge of the detection surface portion 87.

In the example illustrated in FIG. 16, the radial gaps extending in the directions of 0:00 and 6:00 do not pass through the center of the detection surface portion 87 but reach the edge of the detection surface portion 87. The linear gaps extending in the directions of 3:00 and 9:00 pass through the center of the detection surface portion 87 and do not reach the edge of the detection surface portion 87. The radial gaps extending between 1:00 and 2:00, between 4:00 and 5:00, between 7:00 and 8:00, and between 10:00 and 11:00 do not pass through the center of the detection surface portion 87 and do not reach the edge of the detection surface portion 87.

The electric shields 80 shown in FIGS. 15 and 16 both equally suppress eddy current loops. Since the path of the current is shorter in the electric shield 80 illustrated in FIG. 16 than in FIG. 15, the electric resistance is lowered, thereby improving the resistance to external noise.

The electric shield 80 is not limited to the sheet metal configuration. For example, the electric shield 80 may be a coating molded product or a vapor deposition molded product. The coating molded product or the vapor deposition molded product is molded by applying or vapor depositing a conductive material on a bottomed cylindrical resin mold.

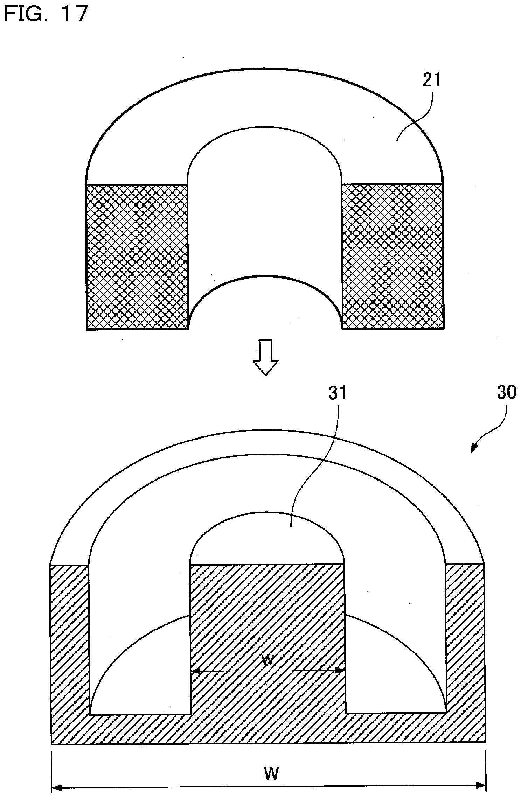

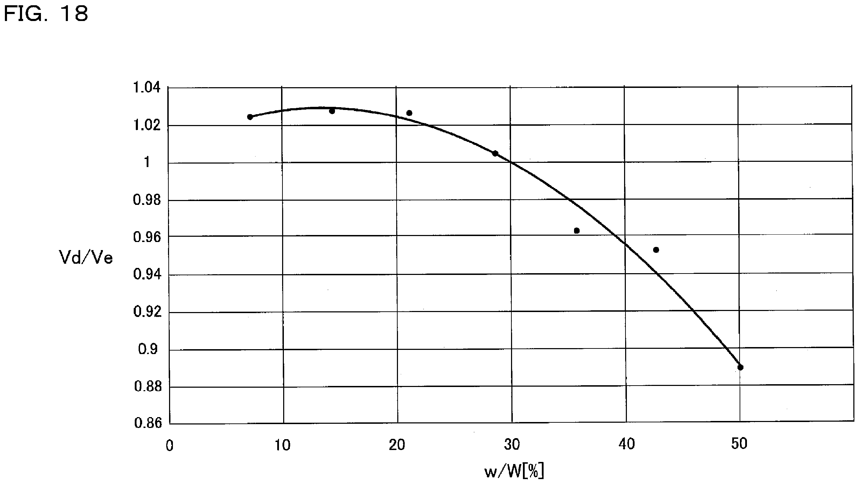

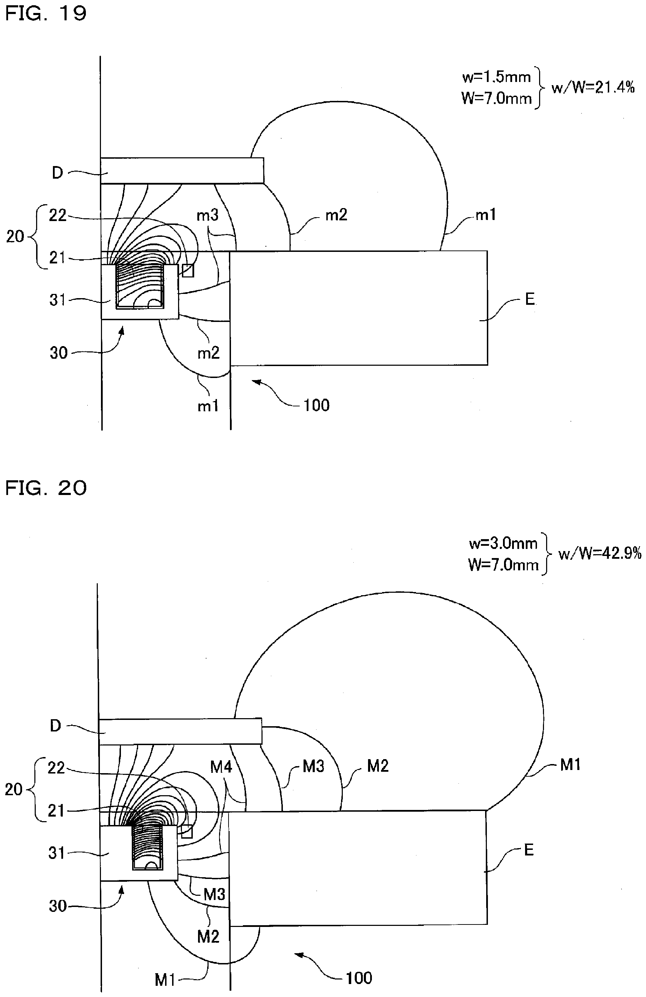

Hereinafter, the ferrite core 30 will be described in detail with reference to FIGS. 17 to 20. FIG. 17 is a central longitudinal sectional view of the first coil 21 and the ferrite core 30. FIG. 18 is a graph illustrating a result of electromagnetic field simulation. FIG. 19 is a magnetic flux diagram in a case where the shaft body 31 of the ferrite core 30 is thin. FIG. 20 is a magnetic flux diagram in a case where the shaft body 31 of the ferrite core 30 is not thin.

As illustrated in FIG. 17, the ferrite core 30 has a shaft body 31. The shaft body 31 passes through the hollow portion of the first coil 21. Hereinafter, in the radial direction, the ratio of the width w of the shaft body 31 to the entire width W of the ferrite core 30 may be referred to as a relative shaft width w/W.

In order to know the relationship between the relative shaft width w/W and the influence of the embedded metal E, electromagnetic field simulation has been performed under the following conditions.

As a condition of the electromagnetic field simulation, the entire width W (outer diameter) of the ferrite core 30 in the radial direction has been set to 7 mm. The width w of the shaft body 31 in the radial direction has been set to the following seven ways. Specifically, the width w of the shaft body 31 in the radial direction has been set to 3.5 mm, 3 mm, 2.5 mm, 2 mm, 1.5 mm, 1 mm, and 0.5 mm. In each of these seven ways, an intensity ratio Vd/Ve has been calculated by dividing a signal intensity Ve of the reception waveform based on the embedded metal E from a signal intensity Vd of the reception waveform based on the detection object D. Note that the signal intensities Vd and Ve of the respective reception waveforms are voltages at both ends of the coil 20.

The results of the electromagnetic field simulation are illustrated in FIG. 18. In the graph illustrated in FIG. 18, the horizontal axis represents the relative shaft width w/W, and the vertical axis represents the intensity ratio Vd/Ve. As is clear from the graph illustrated in FIG. 18, the intensity ratio Vd/Ve has increased as the relative shaft width w/W has decreased. However, when the relative shaft width w/W has decreased to some extent, the intensity ratio Vd/Ve has leveled off.

In particular, when the relative shaft width w/W has been 30% or less, the intensity ratio Vd/Ve has been 1 or more. That is, when the relative shaft width w/W has been 30% or less, the signal intensity Vd of the reception waveform based on the detection object D has been equal to or higher than the signal intensity Ve of the reception waveform based on the embedded metal E.

When the relative shaft width w/W has been less than 15%, the intensity ratio Vd/Ve has been flat. Furthermore, when the relative shaft width w/W is less than 15%, it is difficult to manufacture the ferrite core 30. In other words, when the relative shaft width w/W is 15% or more, the intensity ratio Vd/Ve is high, and manufacturing becomes easy.

When the intensity ratio Vd/Ve is high, the signal intensity Vd of the reception waveform based on the detection object D becomes relatively high. In other words, when the intensity ratio Vd/Ve is high, the signal intensity Ve of the reception waveform based on the embedded metal E becomes relatively low. Therefore, since the relative shaft width w/W is 30% or less, the proximity sensor 100 can sufficiently extend the detection distance by suppressing the influence of the embedded metal E. Further, since the relative shaft width w/W is 15% or more, the proximity sensor 100 can sufficiently extend the detection distance and can be easily manufactured.

From the results of the electromagnetic field simulation, it can be said that the relative shaft width w/W is preferably 30% or less, and more preferably 15% or more and 30% or less.

Next, the magnetic flux lines in the electromagnetic field simulation are illustrated in FIGS. 19 and 20. FIG. 19 illustrates a case where the width w of the shaft body 31 in the radial direction is 1.5 mm, and FIG. 20 illustrates a case where the width w of the shaft body 31 in the radial direction is 3 mm.

In the example illustrated in FIG. 19, since the width w of the shaft body 31 is 1.5 mm and the width W of the entire ferrite core 30 is 7 mm in the radial direction, the relative shaft width w/W is 21.4%. That is, the relative shaft width w/W is 30% or less. As illustrated in FIG. 19, three magnetic flux lines m1 to m3 pass through the embedded metal E.

On the other hand, in the example shown in FIG. 20, since the width w of the shaft body 31 is 3 mm and the width W of the entire ferrite core 30 is 7 mm in the radial direction, the relative shaft width w/W is 42.9%. That is, the relative shaft width w/W is more than 30%. As illustrated in FIG. 20, four magnetic flux lines M1 to M4 pass through the embedded metal E.

As is clear from the comparison between FIGS. 19 and 20, in FIG. 19 in which the relative shaft width w/W has been 30% or less, the number of magnetic flux lines passing through the embedded metal E has been as small as 3, and in FIG. 20 in which the relative shaft width w/W has been more than 30%, the number of magnetic flux lines passing through the embedded metal E has been as large as 4. Therefore, also from FIGS. 19 and 20, it can be said that the influence of the embedded metal E is suppressed when the relative shaft width w/W is 30% or less.

The embodiment is illustrative in all respects and is not restrictive. The scope of the invention is indicated not by the above description but by the claims, and it is intended that meanings equivalent to the claims and all modifications within the scope are included. Among the configurations described in the embodiment, configurations other than the configuration described as one aspect of the invention in "means for solving problems" are arbitrary configurations, and can be appropriately deleted and changed.
(1) In the embodiment, the magnetic shield 90 and the electric shield 80 are illustrated as cylindrical shapes, but may have other shapes such as a square tube shape.
(2) Although the mounting bracket E1 and the double nut E2 have been described as the embedded metal E in which the proximity sensor 100 is embedded, other metals may be used. The other metal is a single nut, a metal block on which an inner screw is formed, or the like. The embedded metal E is merely metal in which the proximity sensor 100 is embedded, and is not a configuration of the proximity sensor 100 itself.
(3) In the embodiment, the transmission circuit 70 is illustrated as one, but the transmission circuit 70 may include a first transmission circuit and a second transmission circuit. The first transmission circuit periodically applies a pulsed excitation current to the first coil 21, and the second transmission circuit periodically applies a pulsed excitation current to the second coil 22.

The invention provides a proximity sensor, and has industrial applicability.

## Claims

1. A proximity sensor comprising:
a coil that generates a magnetic field by an excitation current;
a transmission circuit that periodically applies a pulsed excitation current to the coil; and
a ferrite core that guides the magnetic field generated from the coil, wherein
the coil includes:
a first coil; and
a second coil disposed concentrically with the first coil,
the proximity sensor further comprises:
a reception circuit that detects a voltage or a current generated in at least one of the first coil and the second coil by the magnetic field which is changed by a detection object;
a control circuit that detects the detection object on a basis of a change in the voltage or the current detected by the reception circuit; and
an electric shield having a bottomed cylindrical shape which is disposed outside the second coil in a radial direction,
the electric shield includes:
a peripheral portion covering the second coil from an outside of the second coil in the radial direction; and
a detection surface portion located on a side where the detection object is detected,
a cut crossing a direction around an axis of the electric shield is formed in the detection surface portion and the peripheral portion, and
the electric shield is a press-molded product of a punched thin metal plate in a sheet metal configuration.

2. The proximity sensor according to claim 1, wherein
the reception circuit detects a voltage or a current generated in each of the first coil and the second coil by the magnetic field which is changed by the detection object, and
the control circuit detects the detection object on a basis of a change in the voltage or the current generated in each of the first coil and the second coil detected by the reception circuit.

3. The proximity sensor according to claim 1 or 2, wherein
the second coil is disposed outside the first coil in a radial direction, and
the first coil generates the magnetic field by causing the pulsed excitation current to periodically flow from the transmission circuit.

4. The proximity sensor according to claim 1 or 2, further comprising a substrate on which the transmission circuit, the reception circuit, and the control circuit are provided.

5. The proximity sensor according to claim 2, wherein
the reception circuit includes:
a first reception circuit that detects a voltage or a current generated in the first coil; and
a second reception circuit that detects a voltage or a current generated in the second coil.

6. The proximity sensor according to claim 5, wherein the control circuit detects the detection object on a basis of a difference between the voltage or the current detected by the first reception circuit and the voltage or the current detected by the second reception circuit.

7. The proximity sensor according to claim 1 or 2, wherein the second coil is shorter than the first coil in a direction orthogonal to a radial direction of the second coil.

8. The proximity sensor according to claim 1 or 2, wherein the second coil is located closer to a side where the detection object is detected than the first coil.

9. The proximity sensor according to claim 1 or 2, further comprising
a core holder that holds the ferrite core, wherein
the core holder positions the second coil.

10. The proximity sensor according to claim 1 or 2, further comprising a magnetic shield that is disposed outside the second coil in a radial direction.

11. The proximity sensor according to claim 10, wherein the magnetic shield includes a sheet member kneaded with ferromagnetic powder.

12. The proximity sensor according to claim 1 or 2, wherein
the ferrite core has a shaft body passing through a hollow portion of the first coil, and
a ratio of a width of the shaft body to an entire width of the ferrite core in a radial direction of the first coil is 30% or less.

13. The proximity sensor according to claim 12, wherein a ratio of a width of the shaft body to an entire width of the ferrite core in a radial direction of the first coil is 15% or more.
